# EUROPEAN PATENT SPECIFICATION

(11) **EP 0 629 320 B1**
(45) Date of publication and mention of the grant of the patent: **07.05.1997**
(21) Application number: 93905717.0
(22) Date of filing: 24.02.1993
(51) Int. Cl.: H03H 3/02

(54) **A METHOD AND PLANT FOR THE MANUFACTURE OF PIEZOELECTRICAL RESONATORS**
VERFAHREN UND VORRICHTUNG ZUR HERSTELLUNG VON PIEZOELEKTRISCHEN RESONATOREN
PROCEDE ET INSTALLATION CONCERNANT LA FABRICATION DE RESONATEURS PIEZO-ELECTRIQUES

(30) Priority: 02.03.1992 SE 9200630
(43) Date of publication of application: 21.12.1994
(73) Proprietor: QUARTZ PRO LINE HB, 175 06 Järfälla (SE)
(72) Inventor: LINDBERG, Lennart, S-112 22 Stockholm (SE); GÖRANSSON, Lars-Göran, S-163 63 Spanga (SE); KASEMO, Bengt, S-464 00 Mellerud (SE); KRISTIANSSON, Bo, S-162 45 Vällingby (SE); PORTNOFF, Guy, S-175 48 Järfälla (SE)
(74) Representative: Sundström, Per Olof
(86) International application number: SE9300154
(87) International publication number: WO9318584

(56) References cited:
- US-A- 4 300 272
- US-A- 4 392 287
- US-A- 4 422 226

## Description

The present invention relates to a method for manufacturing resonators of the kind defined in the preamble of Claim 1.

The invention also relates to plant for the manufacture resonators of the kind defined in the preamble of the main apparatus Claim.

A resonator may comprise, for instance, a piezoelectric crystal plate having mounted on its main surfaces a number of metallic electrodes which function to excite the crystal. The frequency of the resonator can be finely adjusted, by adjusting the mass of the electrodes for instance.

### BACKGROUND ART

One problem with prior art technology is that it is not possible to series-manufacture resonators which will remain frequency stable over sufficiently long periods of time, and neither is it possible to produce resonators whose electrical properties can be reproduced sufficiently well, particularly when the resonators included in said series manufacture shall have mutually different frequencies and/or mutually different dynamic parameters.

In recent times, the demand for long-term resonator-frequency stability has become more strict and at present often lies beneath 1 ppm per year, which in the case of AT-crystals which oscillate in shear mode, for instance, corresponds to fractions of an atom layer, calculated as mass on the crystal.

The technique hitherto used is described in "Hy-Q Handbook of Quartz Crystal Devices, David Salt, Van Nostrand Reinhold (UK) Co. Ltd., 1987". This prior art technique comprises some twenty procedural steps, which can be roughly divided into six groups:
1. Mechanical working (grinding/polishing) in various stages to impart a suitable configuration to the crystal. Upon completion of this working process, the crystal has the form of a thin plate whose thickness (typically 0.05-0.5 mm) determines the resonance frequency.
2. Chemical wet etching and cleaning.
3. Application of electrodes, by vapour deposition in vacuum of metal on each side of the crystal.
4. Removal of the crystal in air, and fitting the crystal on a holder and establishing electrical contact with electrically-conductive glue, which is then hardened or cured.
5. Introducing the crystal into a vacuum, so as to further vapourize to a desired frequency while the crystal is connected to an oscillator circuit.
6. Removal of the crystal in air.
7. Encapsulation.

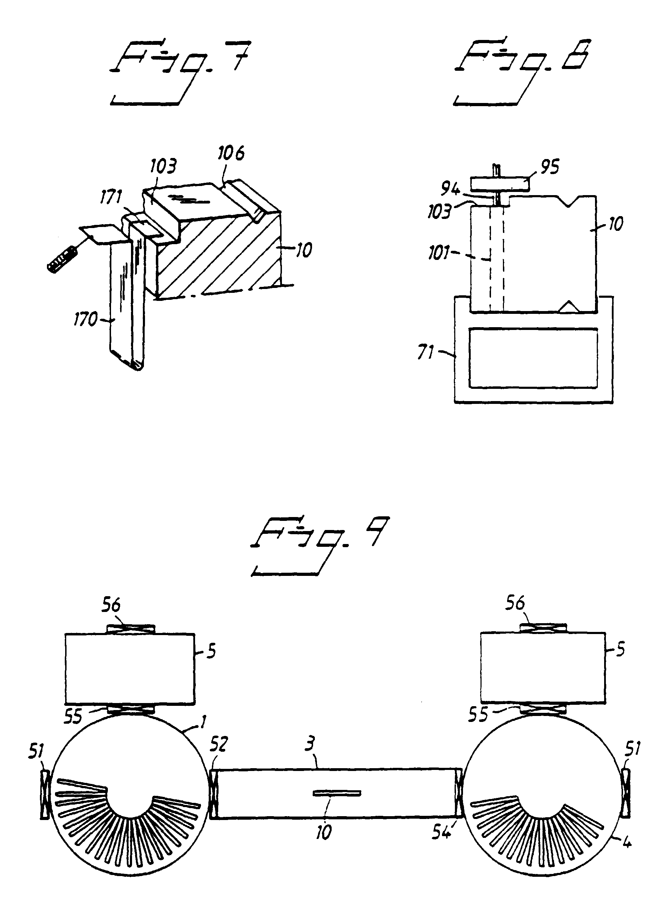

The technique described by Salt results in resonators which age at an unacceptably quick rate, i.e. resonators which have unsatisfactory long-term frequency stability. Furthermore, this known technique also results in crystals whose electrical properties cannot be reproduced sufficiently well, therewith causing a wide spread of the dynamic parameters C₁, L₁ and R₁ of the resonators (c.f. Salt, 1987, Figure 6.1).

In an article "Final Report LABCOM Resonator Phase III" from Pinellas Plant, U.S. Department of Energy,
GEPP-FR-1046, UC-700, certain production conditions are recited for the manufacture of precision resonators of one single kind and frequency, wherein plates each carrying a plurality of crystals are transported in series through production equipment which includes a plurality of series-connected vacuum chambers, in which electrodes are applied to a coarse crystal in the electrode coating chamber, by vapourizing at a pressure of about 2 x 10⁻⁶ mbars. The coating chamber inlet and outlet are connected by means of closure valves to pretreatment chambers and after-treatment chambers which are maintained at a substantial vacuum, wherein the pressure difference from the electrode coating chamber to an adjacent pretreatment chamber or after-treatment chamber is considerably lower than the difference to atmosphere. The crystal frequency is finely adjusted during the electrode coating process.

An UV-treatment process and ozone treatment process is carried out in a pretreatment chamber maintained under vacuum conditions, while a "baking" process is carried out in another treatment chamber connected to said pretreatment chamber, i.e. the plate is subjected to temperature treatment at about 250°C and at a pressure of 2 x 10⁻⁶ mbars prior to being introduced into the electrode coating chamber. The crystal and its holder are sealed in a capsule in the after-treatment chamber.

According to "Final Report...", the known production equipment includes manually-operated manipulators for transferring the individual crystals in the coating chamber between a transport plate and electrode coating stations, which restricts manufacturing capacity.

Other examples of relevant prior art are : US-A-4 300 272, US-A-4 422 226 and US-A-4 392 287.

### DISCLOSURE OF THE PRESENT INVENTION

One object of the present invention is to provide a method and an arrangement of apparatus, hereinafter referred to as plant, which will enable resonators to be produced in series more effectively and in a much more flexible manner than has previously been the case, and by means of which resonators which have high aging stability and which are highly reproducible with respect to their electrical properties can be produced.

Another object of the invention is to enable different resonators in the manufactured series to be given mutually different frequencies and/or mutually different dynamic parameters in a flexible manner. A further object is to enable the production stages to be effectively automated, or to enable the resonator elements to be passed manually through the different process stations in a simple and efficient manner.

Still another object of the invention is to provide a method and plant which will enable the production equipment to be program controlled, and then particularly computer controlled.

A number of the aforesaid objects are achieved by means of the inventive method, having the characteristic features set forth in the independent method Claim. Further developments of the method are set forth in the dependent method Claims.

Other objects of the invention are achieved with the plant defined in the accompanying independent apparatus Claim, while developments of the plant are set forth in the dependent apparatus Claims.

The electrode treatment chamber is preferably an ultra-high vacuum (UVH)-chamber, in which there is established a base pressure which is lower than 10⁻⁶ mbars and preferably lower than 10⁻⁹ mbars.

Those chambers which connect with the electrode coating chamber will preferably be high vacuum (HV)-chambers in which there is established a base pressure which is lower than 10⁻⁵ mbars, and preferably lower than 10⁻⁶ mbars or even lower.

By base pressure is meant the pressure that prevails subsequent to initial evacuation and in the absence of resonators. Subsequent to establishing a vacuum corresponding to these base pressures, process gas can be introduced into respective chambers in a controlled fashion, wherein synthetic air can be introduced into the first and the third chamber while argon can be introduced into the coating chamber. Switching of the carriers between the chambers is always effected at base pressure. The base pressures are established primarily in order to keep recontamination as low as possible.

The cleaning operation is preferably carried out in the coating chamber and includes a dry etching process effected by irradiation with atoms, ions, electrons, photons or plasma. This cleaning operation is carried out at an atomic level, and the piezoelectric plate can then be immediately coated with electrodes, which imparts a very high aging stability to the crystals. The electrodes are formed in the second chamber by means of a PVD-process (Physical Vapor Deposition).

One advantage afforded by the invention is that the resonator element plates can be reached from both sides simultaneously, and according to one preferred embodiment of the invention, electrodes are deposited simultaneously on the two mutually-opposing sides of the piezoelectric plate at the same time as the resultant resonator frequency is detected and the deposition or coating process is regulated so as to obtain a desired frequency with the resonator being electrode-coated. Electrodes are preferably applied to the resonator element in one single production stage.

The electrode coating chamber is connected to ambient atmosphere via vacuum chambers, and in one embodiment of the invention the carriers can be removed from the coating chamber via the pretreatment chamber through which said carriers are delivered to the treatment chamber. One pretreatment chamber may be connected to each end of the electrode coating chamber and while one array of carriers with resonator elements are pretreated in one chamber carriers with resonator elements which have earlier been pretreated in the other pretreatment chamber can be introduced into the electrode coating chamber for electrode deposition or coating and then returned to said pretreatment chamber, from which the carriers can be removed for encapsulation when the pretreated resonator elements in the first chamber are provided with electrodes in the electrode deposition or coating chamber, and vice versa.

The invention will now be described in more detail with reference to a preferred exemplifying embodiment thereof and with reference to the accompanying drawings, in which
- Figure 1: is a schematic, top view of a piezoelectric resonator manufacturing plant constructed in accordance with the invention;
- Figure 2: illustrates a carrier on which a resonator element is transported and treated in said plant;
- Figure 3: illustrates schematically an arrangement for electrode coating a resonator element;
- Figure 4: illustrates schematically a preferred embodiment of an electrode coating or deposition station in said plant;
- Figure 5: is a schematic sectional view taken on the line V-V in Figure 1;
- Figure 6: is a schematic sectional view taken on the line VI-VI in Figure 2;
- Figure 7: illustrates a preferred embodiment of an electrical contact spring for connection to a resonator element during an electrode coating or deposition process;
- Figure 8: illustrates schematically a carrier when carried on a storage rail in a first chamber of the plant; and
- Figure 9: is a schematic top view of a modified production plant.

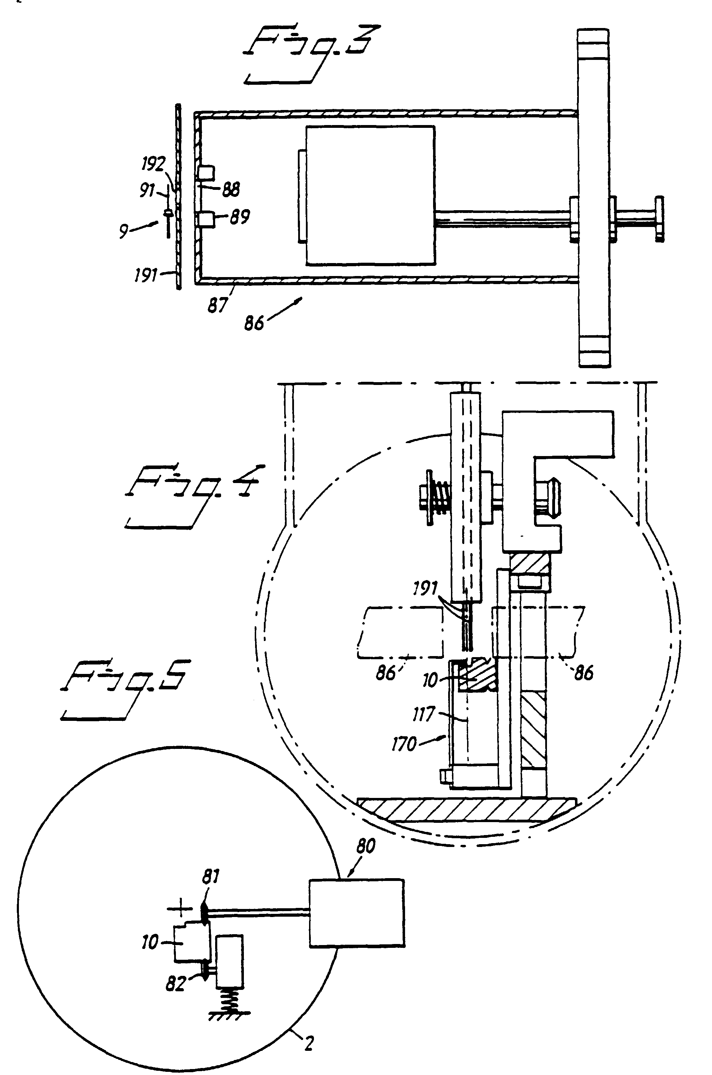

The process also relates to the treatment of resonator elements 9, as described below with reference to Figure 2.

Each element includes a piezoelectric plate 91, for instance a quartz crystal plate 91, which is mounted between two arms 92 on a holder 93, which may be the standard type HC-49/U or HC-50/U. In the illustrated case, the arms 92 are connected to respective conductive pins 94, which extend parallel with and perpendicularly to the holder-plate support surface, said plate 95 holding together the resilient arms 92 and isolating said arms electrically one from the other.

The resonator elements 9 are carefully inspected and adjusted, so that each plate 91 will have a well-defined position in relation to the holder plate 95 and its conductor pins 94, and also relative to the carrier 10 and its markings 104, as described herebelow.

A number of resonator elements 9, for instance 25 resonator elements, are mounted on the carrier 10, as illustrated in Figures 2 and 6. The carrier 10 has the form of a rail which is provided with a pair of mutually parallel holes 101 for each element 9, said holes receiving the pairs of pins 94 on respective elements. The rail 10 is also provided with a support surface 102 which extends perpendicularly to the axes of the holes 101 and which supports the plates 95 of said elements 9. The pins 94 lie in the plane of the plate or disc 91 and all of the holes 101 lie in a common plane, such that the discs 91 of all elements 9 will lie in a common plane with their respective centres located on a straight line, when the elements 9 are mounted on a rail. The holes 101 are formed by ceramic tubes fitted in bores provided in the rail 10 and function to insulate the conductor pins 91 from the rail 10.

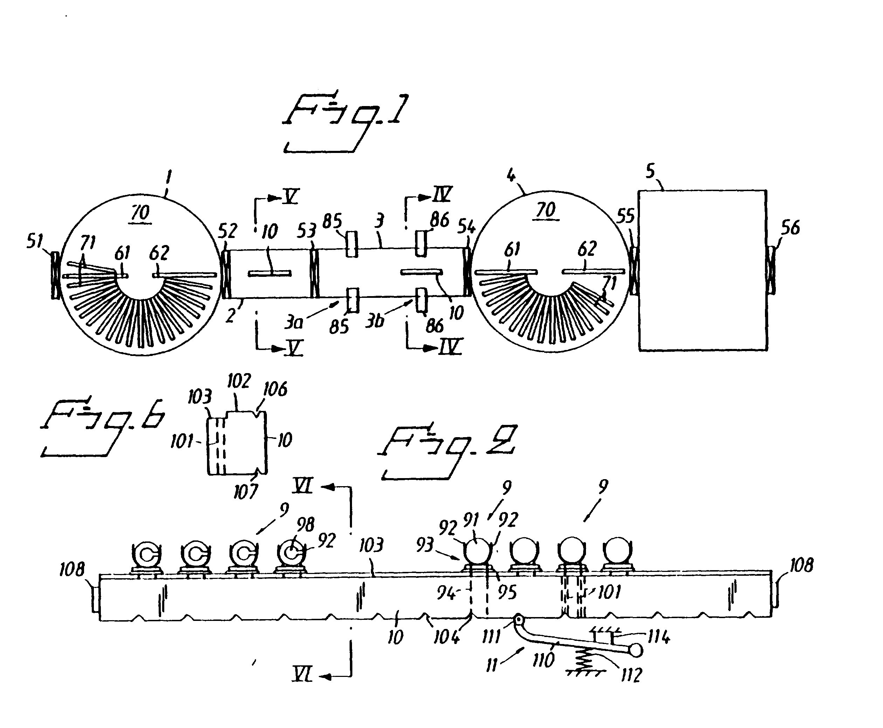

Shown in Figure 1 are magazine chambers 1 and 4, each of which receives a large number of rails 10 for simultaneous treatment of resonator elements carried by said rails. Also shown in Figure 1 are chambers 2 and 3 which are connected in series between the chambers 104 and through which respective rails 10 are advanced singly in their longitudinal directions. Figure 1 also shows the chamber 4 connected to a chamber 5 in which the treated resonator elements are encapsulated, e.g. by resistance welding in a dry and clean protective gas atmosphere or in vacuum.

The chambers 1-5 are arranged in series and are mutually separated by high vacuum feed-valves 52-55, wherein the first chamber 1 and the last chamber 5 have corresponding high vacuum feed-valves 51 and 56 respectively, through which rails 10 can be introduced and removed respectively.

Each of the chambers 1-5 can be connected to vacuum pumps and a gas supply system.

The vacuum pumps are intended to enable the chambers to be given a HV-status or a UHV-status, for instance so as to enable the chambers to be given the following base pressures, after initial down-pumping and in the absence of rails 10 with elements 9: Chambers 1, 2 and 4 better than 10⁻⁶ mbars, and chamber 3 better than 10⁻⁹ mbars.

Subsequent to applying the aforesaid base pressures in the chambers, a suitable gas, which is controlled with respect to impurities, can be introduced into respective chambers, wherein the process can be carried out at a process pressure which is considerably higher than the base pressure.

As illustrated in Figure 1, the chambers 1 and 4 each include a rotational-symmetrical stand 70 which can be rotated about its symmetry axis and which carries a multiple of radially-extending guides 71 for respective rails 10. Also mounted in the magazine chambers 1 and 4 are linear drive mechanism 61, 62 which function to move the rails 10 onto and away from the guides 71. The mechanism 61, 62 may have the form of ball screws which are driven by separate stepping motors. The stand or rack 70 may have the form of a circular carousel plate or turntable which can be rotated to specific angular positions in which the guides 71 are directed towards respective feed-valves 51, 52; 54, 55.

The rails 10 and the elements 9 carried thereby are subjected to a heat treatment process in chamber 1 (at a temperature of 200°C or higher) in vacuum for a relatively long period of time, so as to expel water vapour and other volatile substances that may have settled on the surfaces of the rails and elements. The pressure in the chamber 1 is measured by way of a process check, this pressure being dependent on the evacuation of gas from the crystals 91. The heat treatment process is continued in the chamber 1 until the correct pressure prevails therein. The rails 10 and the element 9 carried thereby are then allowed to cool, whereafter one rail 10 at a time is introduced into the chamber 2, where the elements are subjected to an oxidizing treatment process with ozone and UV light. Those organic impurities, such as hydrocarbons, which remain on the elements 9 subsequent to their treatment in the chamber 1 will be decomposed and oxidized to carbon dioxide and water vapour, which is pumped away. A positive assessment of the degree of purity of the crystals can be obtained by measuring the partial pressure of, e.g., carbon dioxide in the chamber 2, so as to achieve uniform purity of the crystals from rail to rail. This residual gas analysis is carried out in a separate system, which is normally held closed from the chamber 2, except when samples are taken.

In an alternative embodiment of the inventive equipment or plant, the chamber 2 can either be omitted or used as a feed-valve between the chamber 1 and the treatment chamber 3, while the UV-ozone-treatment process can be carried out in the chamber 1 simultaneously with the vacuum-heat-treatment process carried out therein.

As illustrated in Figure 5, the rail 10 is moved through the chambers 2 and 3 in the direction of its longitudinal axis, by means of a transport arrangement 80. Provided in the upper surface of the rail 10 is a groove 106 which extends in the longitudinal direction of the rail 10 and which is preferably V-shaped in cross-section (see Figure 6). The undersurface of the rail 10 is provided with a corresponding groove 107, which extends parallel with the groove 106. The transport arrangement 80 includes a number of wheel pairs 81, 82, the wheel peripheries of which engage in the grooves 106, 107 on the rail 10. As indicated in Figure 5, one wheel 82 may be spring biased in a direction towards the other wheel 81, and one of the wheels, e.g. 81, may be driven for axial movement of the rail 10.

The guides/rails 71 (see Figure 1) can be aligned on the transport arrangement 80 so as to enable rails 10 to be transferred linearly to and from said arrangement. As will be seen from Figure 2, at least the forward end of respective rails 10, as seen in the withdrawal direction, as a magnetic screw 108 which enables the rails to be coupled to the linear drive mechanism 61, 62 concerned.

The chamber 3 is constructed so as to be ultra-high-vacuum compatible (UHV), i.e. to permit a vacuum of 10⁻⁹ mbars to be established therein. One condition which must be satisfied in order to be able to maintain a pressure of such low magnitude in the chamber 3, despite the large passage of material therethrough, is primarily that the rails 10 and the elements 9 introduced into said chamber are sufficiently clean to ensure that no gas will be released therefrom and into the chamber 3. It is also necessary to surround the chamber 3 with chambers (the chambers 2 and 4 respectively) which are maintained at a pronounced subpressure when the feed-valve 53, 54 is opened, thereby minimizing the amount of contaminating material that can possibly be transferred to the chamber 3.

The illustrated chamber 3 has two treatment positions 3a, 3b which are mutually separated in the longitudinal direction of the chamber.

As illustrated in Figure 2, the rail 10 has markings 104, which in the illustrated case have the form of milled notches which correspond to the positions of each respective resonator element along the rail 10. When the rail 10 is moved in the direction of its longitudinal axis, the position of each marking is detected, so as to enable the rail to be locked in a position which unambiguously defines the position of the associated crystal element 9. It will be understood that the notches 104 can be replaced with corresponding holes, pins or some other identification means, and that the position of respective markings can be detected mechanically, electromechanically inductively, capacitively or optically. Shown in Figure 2 is a position setting device 11 which includes a pivotally mounted arm 110 which has mounted on its free end a rotatably journalled roller, or alternatively a pointed latching device 111. A spring 112 biases the arm 110 in a direction towards the undersurface of the rail 10, such as to drive the device 111 into a recess 104, so as to place an element 9 in a given position. A detecting device 114 may be provided for detecting engagement of the pointed device 110 in a recess 104, for the purpose of controlling the drive arrangement 80 or for indicating that a crystal 9 has taken a given position.

In position 3a (Figure 1), which corresponds to one station in which the individual elements 9 are temporarily held, there is positioned on each side of the position of the crystal disc 91 an irradiating device which dry-etches off any remaining contaminants with the aid of energy-rich beams of atoms, ions, photons or electrons. This etching process is continued until the major surfaces of the disc 91 are atomically clean, or may be continued until the thickness of the disc 91 has been reduced, whereby this process step is able to serve to establish a quartz disc or plate of given thickness. Alternatively, the etching process in the station 3a may be used to subsequently remove (sputter off) electrode material so as to increase the frequency of the element 9. This etching method may also be used to adjust the frequency of "lateral field resonators" which lack electrodes on their major surfaces. The energy-rich atoms, ions or electrons are generated in "atom guns", in ion beam sources or by high frequency discharge on an appropriate process gas, such as argon for instance.

The rail 10 is advanced in the direction of its longitudinal axis such that each cleaned element 9 is held temporarily in the position 3b (Figure 1), where the element 9 is coated with an appropriate electrode metal, e.g. gold, by means of a PVD-process (Physical Vapor Deposition), e.g. by vapourizing or preferably sputtering (cathode atomization) from two coating devices placed on a respective side of the crystal in position 3b, wherein preferably two sputter magnetrons are stationarily mounted on a respective side of the movement path of the crystal discs 91.

The beams of sputtered or vapourized metal are defined by masks 191 which are provided with apertures 192 which determine the desired electrode form on the crystal, Figure 3.

Illustrated to the left of Figure 2 is an element 9 on which electrodes 98 are applied, each electrode being connected to its respective holder arm 92.

As illustrated in Figure 4, the sputtering magnetrons 86 are directed towards one another equidistant from the path along which the discs 91 move, and the masks 191 are disposed on each side of said path, the centre plane of which is indicated by the chain line 117.

In accordance with one preferred embodiment, the masks 191 have the form of two mutually parallel discs which are provided with pairs of different mask-apertures or openings around their periphery and which can be rotated so as to index the mask-apertures into positions opposite a crystal disc which is held temporarily stationary in the position 3b. The different mask-apertures may be adapted to different types of resonator elements and, as illustrated in Figure 4, are rotated forwards to working positions by means of an externally driven mechanism.

Also illustrated schematically in Figure 4 is the pair of contact springs 170 which establish contacts with the pins 94 on an element 9 located in the treatment position 3b. A preferred embodiment, 171, of the springs is shown in Figure 7.

As shown in Figure 3, the sputtering magnetron 86 may be screened by a housing 87 having an opening 88 which functions to direct metal vapour essentially solely onto the element 9 in position 3b.

It is important to have accurate control over the crystal temperature during the coating process, since the resonator frequency is also dependent on temperature. The disc or plate 91 is unavoidably heated, as it is bombarded with the metal atoms which build-up the metal film (mean energy about 1 eV). Furthermore, thermal electrons (mean energy about 2-5 eV, i.e. electron temperatures 20,000-50,000 K) are generated from the gas discharge plasma in the magnetrons. If these thermal electrons should strike the disc 91, the disc would be heated so powerfully as to render accurate adjustment of the frequency impossible. Consequently, the magnetron 86 is provided with an electron trap 89, e.g. in the form of means which will generate a transversal or axial magnetic field (mirror field) at the orifice 88 of the housing 87, or in the form of a retarding electric field. The chamber 3 is also provided with a heat exchanger, for instance in the form of a conduit, which is in contact with the outside of the chamber 3 and through which cold water flows, so as to regulate the temperature of the chamber walls. This enables a suitable temperature (e.g. +25 or +85°C) to be maintained in respect of the element 9 during the coating process.

As indicated in connection with Figure 4, the pins 94 on elements 9 are connected via electric connector springs 170 to an appropriate high frequency circuit (active oscillator or passive transmission circuit or reflection circuit) which through the piezoelectric effect engendered excites mechanical oscillations in the crystal (in the illustrated embodiment shear oscillations), wherewith the resonance frequency falls (decreases) during the electrode coating process, the frequency being monitored so as to enable the element 9 to be given a desired frequency.

The high frequency measuring circuit may be constructed, for instance, in accordance with standard IRV-444. However, the connector elements will preferably be resilient in the case of the illustrated embodiment, and to this end each of the connector springs is preferably constructed in the manner illustrated in Figure 7, namely as a folded spring strip with a small gap between the legs and with a large width, wherein the free end-part 171 of the spring element is intended to be received in the recess 103 beneath the holder plate 95 and to establish electrical contact with a respective pin 94 when the element 9 is in the position 3b. The other end of the connector spring is connected first to a pi-network and thereafter to the measuring equipment of the circuit, by means of a coaxial cable, the configuration of the spring connector provide a minimum inductance.

Subsequent to coating each element 9 on a rail with electrodes and adjusting the frequency of said each element, the rail 10 is moved into the magazine chamber 4. When the chamber 4 has been filled with a batch of rails 10, the elements 9 are subjected to an annealing process in vacuum over a suitable period of time, therewith relaxing any mechanical stresses that may have built up in the electrofilm 98 and removing any residual noble gas from the magnetron discharges.

The rails 10 are then moved into the chamber 5, where the elements 9 are encapsulated.

Figure 9 illustrates plant which includes chambers 1 and 4 of the earlier described construction, having feed-valves 51 for the introduction of carriers 10 with resonator elements to be treated in accordance with the invention.

The chambers 1 and 4 are also connected to a common electrode coating or deposition chamber 3, via valves 52 and 54. Furthermore, each of the chambers 1 and 4 is connected to an associated encapsulating chamber 5, via valves 55, from which carriers with encapsulated resonator elements can be taken through a feed-valve 56.

The initial process step in which the resonator elements are cleaned before being introduced into the electrode coating chamber is normally a time-consuming operation which may take as long as six hours, for instance. The working capacity of the chamber 3 can be extended two-fold, by dimensioning the chambers 1 and 4 in a manner which will enable the chambers to accommodate a large number of carriers and resonator elements. For instance, during the time in which resonator elements are cleaned in the chamber 1, elements which have already been cleaned in the chamber 4 can be introduced into the chamber 3 carried by respective carriers 10 for electrode coating and frequency adjustment, one carrier being introduced into the chamber 3 at a time and then returned to its rail in the chamber 4. Treated carriers with resonator elements can then be removed via the valve 55 and encapsulated in the chamber 5, whereafter other carriers with elements to be cleaned are introduced into the chamber 4, while elements that have been cleaned in the chamber 1 are electrode coated in the chamber 3.

If required, the chamber 3 can be equipped with several working positions or may be divided into a sequence of separate chambers. This affords the possibility of new or alternative process steps, such as:
a. Coating the resonator elements with an alternative metal, for instance aluminium or silver;
b. Pre-coating the resonator elements with material which will improve the adhesion of the electrode film;
c. Pre-coating the resonator elements with material which will minimize mechanical stresses;
d. Coating the resonator elements with a protective layer which will passivate the electrode surface against gas adsorption, etc.;
e. Oxidizing the electrosurface (particularly in the case of aluminium electrodes);
f. Separate coating positions for the application of a primary plating and a complementary coating for frequency adjustment purposes;
g. Frequency adjustment by sputtering-off electrode material applied with a primary coating; and
h. Frequency adjustment by etching the quartz surface in the manufacture of "lateral field resonators".

The sputter magnetrons can either be operated with solely a negative d.c. voltage which is applied to the cathode (the target electrode), or with a d.c. voltage together with a superposed high frequency voltage (e.g. 13.56 MHz). The HF-discharge gives rise to a population of energy-rich argon ions, which bombard the substrate during the ongoing plating process and knock loose or move atoms which are weakly bound to the electrode film. This results in a denser metallic film having the same electrical conductivity as solid metal.

Alternatively, ion beam sputtering can be used. In this case, the target electrode has the form of a rod or a strip whose one end is sputtered with the aid of a high energy ion beam from an ion source. The rod is advanced successively as it is consumed.

## Claims

1. A method for manufacturing resonators, each of which includes a holder (93) having at least two mutually separate holder elements (92) which are connected to a respective connection conductor (94), and a piezoelectric disc (91) which has a centre plane between its mutually opposing major surfaces and which is mounted on and conductively fixed to the holder elements (92) such as to form a resonator element, wherein an electrode (98) is applied on each of the major surfaces of the disc (91) and is connected electrically to a respective holder element (92), said method comprising the steps of placing a plurality of pre-manufactured resonator elements (9) on a carrier device; introducing the carrier device (10) into a first vacuum chamber (1) for cleaning the carrier therein at a first vacuum level; transferring the carrier (10) with elements (9) directly from the first chamber (1) to a second vacuum chamber (3) which is connected to said first chamber and in which a second vacuum level prevails; applying electrode material to the resonator elements in said second chamber (3); finely adjusting the resonator frequency of the electrode-coated resonator element in said second chamber to a desired value; and transferring the carrier (10) together with said electrode-coated and frequency-adjusted resonator element from the second chamber (3) to a third chamber (4) connected to said second chamber (3), said third chamber forming a carrier outfeed gate valve, **characterized** by the further steps of mounting a plurality of resonator elements (9) on the carrier (10) in a row, with the centre plane of each disc (91) oriented in the longitudinal direction of said row; moving the carrier (10) in the longitudinal direction of the row in said second chamber, along a given path; stopping said longitudinal movement of the carrier so as to position the disc (91) of each element (9) temporarily in a given position (3b), wherein at least one stationarily mounted coating device (86) is directed against one associated major surface of the disc (91) in said given position (3b), and wherein said coating device is caused to apply electrode material to the resonator element while said element is held in said given position.

2. A method according to Claim 1, **characterized** in that the first and the third chambers (1, 4) are high vacuum chambers; in that the second chamber (3) is a ultra-high vacuum chamber; and in that subsequent to being evacuated, gas is introduced into at least one of the chambers in a controlled fashion until a desired process pressure is reached.

3. A method according to Claim 1 or 2, **characterized** by carrying out a heat treatment process under vacuum or in a process gas environment in at least one of the chambers (1, 4) which connects with the second chamber (3).

4. A method according to Claim 1 or 2, **characterized** in that the resonator elements (9) are etched clean in the second chamber (3) by irradiating said elements with atoms, ions, electrons, photons, or plasma, preferably atoms; and in that the radiating devices (85) are preferably mounted in fixed positions opposite one another on both sides of the movement path of the element discs (91) in a longitudinal position (3a) for the elements (9) at which said elements are temporarily held stationary and centered in relation with irradiating devices (85) during the etching process.

5. A method according to any one of Claims 1-4, **characterized** by treating the resonator elements with UV-light and ozone, prior to introducing said elements into the second chamber (3).

6. A method according to Claim 5, **characterized** by carrying out the UV and ozone treatment process in a separate pretreatment chamber (2) which is connected between the first chamber (1) and the second chamber (3) and which can be separated from said first and second chambers by means of feed-valves (52, 53).

7. A method according to any one of Claims 1-6, **characterized** by electrode coating both major surfaces of the disc (91) simultaneously in the second chamber (3), with the aid of two mutually opposing coating devices (86).

8. A method according to any one of Claims 1-7, **characterized** by monitoring the temperature of the resonator element during the electrode coating process, with the aid of a thermostat.

9. A method according to any one of Claims 1-8, **characterized** by effecting the electrode coating process with the aid of a sputtering process, and preventing electrons generated at the coating from impinging on the disc (91).

10. A method according to any one of Claims 1-9, **characterized** by also applying to the sputtering source a positive d.c. voltage and/or a high frequency voltage relative to the disc (91).

11. A method according to any one of Claims 1-10, **characterized** by detecting the resonator frequency in the electrode coating position and preferably electrode-coating the element in one single electrode coating stage.

12. A method according to any one of Claims 1-11, **characterized** by treating a plurality of carriers (10) each carrying a plurality of resonator elements (9) simultaneously in the first chamber (1); and transferring the carriers (10) to the second chamber, preferably singly and in the direction of their longitudinal axis.

13. A method according to any one of Claims 1-12, **characterized** in that two masking plates (191) provided with a number of pairs of associated electrode masking holes are moveably arranged in the second chamber (3) such as to position selected masking holes associated with one pair between respective major surfaces of the disc (91) and a corresponding coating device (86).

14. A method according to any one of Claims 1-13, **characterized** by carrying out a UV-ozone-treatment process in either the first chamber (1) or the third chamber (4).

15. A method according to any one of Claims 1-14, **characterized** in that the first chamber (1) and the third chamber (4) are one and the same chamber; and in that the carrier is removed from the treatment chamber through the same pretreatment chamber as that through which it was introduced into said coating chamber.

16. A method according to any one of Claims 1-15, **characterized** by returning the carriers (10) to the first chamber subsequent to being electrode coated.

17. A method according to Claim 16, **characterized** by subjecting an array of carriers (10) with resonator elements to a high vacuum process in the third chamber (4) while an array of carriers (10) with resonator elements treated in the first chamber (1) are electrode coated in the second chamber (3).

18. A manufacturing plant for the production of resonators, each of which includes a holder (93) having at least two mutually separated holder elements (92) which are connected to respective connecting conductors (94), and a piezoelectric disc (91) which has its centre plane between its mutually opposing major surfaces and which is mounted on and fixed in an electrically conductive fashion to the holder elements (92) such as to form a resonator element (9), wherein an electrode (98) is mounted on each of the major surfaces of the disc (91) and is electrically connected to a respective holder element (92); wherein the plant includes vacuum chambers (1, 3, 4) in which the resonators are transported while carried on respective carriers (10), wherein the chambers (1, 3, 4) include a first treatment chamber (1) in which the resonator elements are cleaned; a second treatment chamber (3) in which electrode coatings (98) are applied on the resonator elements (9), said chamber (3) being connected with the first chamber (1) via a closure valve (52), and a third chamber, an after-treatment chamber (4) which connects with the coating chamber (3) via a closure valve (54) and forms a gate valve for the removal of carriers from the treatment chamber, **characterized** in that the carrier (10) is provided with means (101) for supporting a plurality of resonator elements (9) in a row, with the symmetry plane of respective crystal discs (91) oriented in the longitudinal direction of said row; in that transport means (80-82) are arranged to drive the carriers (10) in the electrode coating chamber in a given path in the direction of the rows of discs (91) on the carriers (10); in that means (11, 104) are arranged to hold each resonator element (9) temporarily in a given position (3b) along the path in said second chamber (3); and in that electrode coating means (86) are arranged on at least one side of the disc movement path and are directed towards an associated major surface of a disc located in said given position (3b).

19. A plant according to Claim 18, **characterized** by an externally controllable masking device positioned in the coating chamber (3) and comprising two masking plates (191) which are provided with a number of pairs of masking holes (192), wherein the resonator elements are intended to pass between the masking plates in said coating position for the purpose of aligning the masking holes with each resonator element disc.

20. A plant according to Claim 18 or 19, **characterized** in that the first chamber (1) and/or the third chamber (4) is intended to accommodate a plurality of carriers (10), each carrying a plurality of resonator elements for simultaneous cleaning of said carriers and said elements; and in that means are provided for individually aligning a carrier (10) in a respective first and third chamber (1; 4); and in that transport devices (80) are provided for linear transfer of a carrier.

21. A plant according to any one of Claims 18 and 20, **characterized** in that the carriers (10) are made of metal.

22. A plant according to any one of Claims 18 and 20, **characterized** in that the carriers (10) are made of an insulating material, such as a ceramic or glass material.

23. A plant according to any one of Claims 18-22, **characterized** by spring devices (170) which, in said electrode coating position (3b), function to connect the conductors (94) of the resonator element (9) to a frequency detecting circuit.

24. A plant according to any one of Claims 18-23, **characterized** in that the transport device (80) includes corresponding rollers (81, 82) which engage respective opposing longitudinally extending grooves (106, 107) in the carrier (10); and in that the grooves (106, 107) extend parallel with the direction of said row of resonator elements (9); in that at least one (81) of the rollers is driven; and in that at least one (82) of the rollers is moveably mounted such as to clamp the bar (10) resiliently against fixed guide rollers.

25. A plant according to any one of Claims 18-24, **characterized** in that the first chamber (1) and/or the third chamber (4) includes a rotatable rack (70) which is provided with a plurality of generally radially extending guides (71) which function to support individual carriers (10); in that the guides (71) are intended to guide a respective carrier (10) for movement in the direction of the row of resonator elements; in that the rack (70) is rotatable to positions in which the individual guides (71) guide a carrier (10) towards the transport device (80); and is further characterized by a pushing device (61, 62) for pushing a carrier (10) along its guide (71).

26. A plant according to any one of Claims 18-25, **characterized** in that dry etching devices (85) are stationarily mounted in the second chamber (3) on at least one side of the path travelled by the resonator discs (91); and in that means (11, 104) are provided for holding the resonator disc (91) of each resonator element (9) temporarily in the position of the working station of said etching devices.

27. A plant according to any one of Claims 18-26, **characterized** in that the electrode coating devices includes at least one sputter magnetron source which is surrounded by a preferably cooled housing (87) having an outlet opening (88) in which a magnet (89) is mounted for impeding electrones.

28. A plant according to any one of Claims 18-27, **characterized** in that the electrode coating devices include sputter magnetron sources which are provided with a separate anode to which a d.c. voltage for a high frequency can be applied.

29. A plant according to any one of Claims 18-28, **characterized** in that the electrode coating chamber (3) is provided with a heat exchanger for adjusting the temperature of the resonator elements during the electrode coating process.

30. A plant according to any one of Claims 18-29, **characterized** in that at least one of the chambers (1, 4) connected to the electrode coating chamber (3) is provided with means for heat treating the resonator elements under high vacuum conditions or in a process gas environment.

31. A plant according to any one of Claims 18-30, **characterized** in that means for effecting an oxidizing treatment are arranged in at least one of the chambers (1, 4) connected to the electrode coating chamber (3), said oxidizing means preferably being arranged in a separate, additional chamber (2) which is connected between the first chamber (1) and the second chamber (3).

32. A plant according to any one of Claims 19-31, **characterized** in that the first chamber and the third chamber (4) are one and the same chamber.

## Patentansprüche

1. Verfahren zur Herstellung von Resonatoren, von welchen jeder einen Halter (93), welcher mindestens zwei gegenseitig getrennte Halterelemente (92) hat, welche mit einem jeweiligen Verbindungsleiter (94) verbunden sind, und eine piezoelektrische Scheibe (91) enthält, welche eine Mittelebene zwischen ihren gegenseitig gegenüberliegenden Hauptflächen hat und welche auf den Halterelementen (92) angebracht und leitfähig befestigt ist, um so ein Resonatorelement zu bilden, wobei eine Elektrode (98) auf jeder der Hauptflächen der Scheibe (91) angebracht und elektrisch mit einem jeweiligen Halterelement (92) verbunden ist, wobei das Verfahren folgende Schritte enthält: Plazieren einer Vielzahl von vorgefertigten Resonatorelementen (9) auf einer Trägervorrichtung; Einführen der Trägervorrichtung (10) in eine erste Vakuumkammer (1) zum Reinigen des Trägers darin bei einem ersten Vakuumniveau; Überführen des Trägers (10) mit Elementen (9) direkt von der ersten Kammer (1) zu einer zweiten Vakuumkammer (3), welche mit der ersten Kammer verbunden ist und in welcher ein zweites Vakuumniveau vorherrscht; Anbringen von Elektrodenmaterial an den Resonatorelementen in der zweiten Kammer (3); Feineinstellung der Resonatorfrequenz des Elektroden-beschichteten Resonatorelements in der zweiten Kammer auf einen gewünschten Wert; und Überführen des Trägers (10) zusammen mit dem Elektroden-beschichteten und Frequenz-eingestellten Resonatorelement von der zweiten Kammer (3) zu einer dritten Kammer (4), welche mit der zweiten Kammer (3) verbunden ist, wobei die dritte Kammer ein Träger-Ausfuhrtor-Ventil bildet,
**gekennzeichnet durch**
die weiteren Schritte: Befestigen einer Vielzahl von Resonatorelementen (9) auf dem Träger (10) in einer Reihe, wobei die Mittelebene jeder Scheibe (91) in der Längsrichtung der Reihe ausgerichtet ist; Bewegen des Trägers (10) in der Längsrichtung der Reihe in der zweiten Kammer entlang eines gegebenen Weges; Stoppen der Längsbewegung des Trägers, um so die Scheibe (91) jedes Elements (9) vorübergehend in einer gegebenen Position (3b) zu positionieren, in welcher mindestens eine ortsfest befestigte Beschichtungsvorrichtung (86) gegen eine zugeordnete Hauptfläche der Scheibe (91) in der gegebenen Position (3b) gerichtet ist und in welcher die Beschichtungsvorrichtung veranlaßt wird, Elektrodenmaterial auf das Resonatorelement aufzutragen, während das Element in der gegebenen Position gehalten wird.

2. Verfahren nach Anspruch 1,
**dadurch gekennzeichnet**,
daß die ersten und dritten Kammern (1, 4) Hochvakuum-Kammern sind, daß die zweite Kammer (3) eine Ultrahochvakuum-Kammer ist,und daß nach dem Evakuieren Gas in mindestens eine der Kammern auf eine kontrollierte Weise eingeführt wird, bis ein gewünschter Betriebsdruck erreicht ist.

3. Verfahren nach Anspruch 1 oder 2,
**gekennzeichnet durch**
Ausführen eines Wärmebehandlungs-Verfahrens unter Vakuum oder in einer Betriebsgas-Umgebung in mindestens einer der Kammern (1, 4), welche mit der zweiten Kammer (3) in Verbindung steht.

4. Verfahren nach Anspruch 1 oder 2,
**dadurch gekennzeichnet**,
daß die Resonatorelemente (9) in der zweiten Kammer (3) rein geätzt werden durch Bestrahlen der Elemente mit Atomen, Ionen, Elektronen, Photonen oder Plasma, vorzugsweise Atomen, und daß die Bestrahlungsvorrichtungen (85) vorzugsweise in festen Position einander gegenüberliegend auf beiden Seiten des Bewegungsweges der Elementscheiben (91) in einer Längsposition (3a) für die Elemente (9) befestigt sind, bei welcher die Elemente vorübergehend stationär gehalten werden und im Verhältnis zu Bestrahlungsvorrichtungen (85) während des Ätzverfahrens zentriert werden.

5. Verfahren nach einem der Ansprüche 1 bis 4,
**gekennzeichnet durch**
Behandeln der Resonatorelemente mit UV-Licht und Ozon vor Einführung der Elemente in die zweite Kammer (3).

6. Verfahren nach Anspruch 5,
**gekennzeichnet durch**
Ausführen des UV- und Ozon-Behandlungsverfahrens in einer getrennten Vorbehandlungskammer (2), welche zwischen der ersten Kammer (1) und der zweiten Kammer (3) verbunden ist und welche von den ersten und zweiten Kammern mittels Zufuhrventilen (52, 53) getrennt werden kann.

7. Verfahren nach einem der Ansprüche 1 bis 6,
**gekennzeichnet durch**
gleichzeitiges Elektrodenbeschichten beider Hauptflächen der Scheibe (91) in der zweiten Kammer (3) mit Hilfe von zwei gegenseitig gegenüberliegenden Beschichtungsvorrichtungen (86).

8. Verfahren nach einem der Ansprüche 1 bis 7,
**gekennzeichnet durch**
Überwachen der Temperatur des Resonatorelements während des Elektroden-Beschichtungsverfahrens mit Hilfe eines Thermostats.

9. Verfahren nach einem der Ansprüche 1 bis 8,
**gekennzeichnet durch**
Bewirken des Elektroden-Beschichtungsverfahrens mit Hilfe eines Sputter-Verfahrens und Verhindern, daß Elektronen, welche an der Beschichtung erzeugt werden, auf die Scheibe (91) aufschlagen.

10. Verfahren nach einem der Ansprüche 1 bis 9,
**gekennzeichnet durch**
ebenfalls Anlegen einer positiven Gleichspannung und/oder einer Hochfrequenzspannung an der Sputterquelle relativ zur Scheibe (91).

11. Verfahren nach einem der Ansprüche 1 bis 10,
**gekennzeichnet durch**
Ermitteln der Resonatorfrequenz in der Elektroden-Beschichtungsposition und vorzugsweise ElektrodenBeschichten des Elements in einem einzigen Elektroden-Beschichtungsschritt.

12. Verfahren nach einem der Ansprüche 1 bis 11,
**gekennzeichnet durch**
gleichzeitiges Behandeln einer Vielzahl von Trägern (10), von welchen jeder eine Vielzahl von Resonatorelementen (9) trägt, in der ersten Kammer (1), und Überführen der Träger (10) zur zweiten Kammer, vorzugsweise einzeln und in der Richtung ihrer Längsachse.

13. Verfahren nach einem der Ansprüche 1 bis 12,
**dadurch gekennzeichnet**,
daß zwei maskierende Platten (191), welche mit einer Anzahl von Paaren zugeordneter Elektroden-Maskierungslöcher versehen sind, beweglich in der zweiten Kammer (3) angeordnet sind, um so ausgewählte Maskierungslöcher, welche einem Paar zugeordnet sind, zwischen den jeweiligen Hauptflächen der Scheibe (91) und einer zugehörigen Beschichtungsvorrichtung (86) zu positionieren.

14. Verfahren nach einem der Ansprüche 1 bis 13,
**gekennzeichnet durch**
Ausführen eines UV-Ozon-Behandlungsverfahrens entweder in der ersten Kammer (1) oder in der dritten Kammer (4).

15. Verfahren nach einem der Ansprüche 1 bis 14,
**dadurch gekennzeichnet,**
daß die erste Kammer (1) und die dritte Kammer (4) ein und dieselbe Kammer sind, und daß der Träger von der Behandlungskammer durch die gleiche Vorbehandlungskammer entfernt wird, wie die, durch welche er in die Beschichtungskammer eingeführt wurde.

16. Verfahren nach einem der Ansprüche 1 bis 15,
**gekennzeichnet durch**
Rückführen der Träger (10) zur ersten Kammer, nachdem sie Elektroden-beschichtet wurden.

17. Verfahren nach Anspruch 16,
**gekennzeichnet durch**
Unterziehen einer Anordnung von Trägern (10) mit Resonatorelementen einem Hochvakuum-Verfahren in der dritten Kammer (4) während eine Anordnung von Trägern (10) mit Resonatorelementen, welche in der ersten Kammer (1) behandelt wurden, in der zweiten Kammer (3) Elektroden-beschichtet werden.

18. Produktionsanlage für die Herstellung von Resonatoren, von welchen jeder einen Halter (93), welcher mindestens zwei gegenseitig getrennte Halterelemente (92) hat, welche mit jeweiligen Verbindungsleitern (94) verbunden sind, und eine piezoelektrische Scheibe (91) enthält, welche ihre Mittelebene zwischen ihren gegenseitig gegenüberliegenden Hauptflächen hat und welche auf den Halterelementen (92) angebracht und in einer elektrisch leitfähigen Weise an ihnen befestigt ist, um so ein Resonatorelement (9) zu bilden, wobei eine Elektrode (98) auf jeder der Hauptflächen der Scheibe (91) angebracht und elektrisch mit einem jeweiligen Halterelement (92) verbunden ist, wobei die Anlage Vakuumkammern (1, 3, 4) enthält, in welchen die Resonatoren transportiert werden, während sie auf jeweilgen Trägern (10) getragen werden, wobei die Kammern (1, 3, 4) eine erste Behandlungskammer (1), in welcher die Resonatorelemente gereinigt werden, eine zweite Behandlungskammer (3), in welcher Elektrodenbeschichtungen (98) auf die Resonatorelemente (9) aufgebracht werden, wobei die Kammer (3) mit der ersten Kammer (1) über ein Verschlußventil (52) verbunden ist, und eine dritte Kammer, eine Nachbehandlungskammer (4) enthalten, welche mit der Beschichtungskammer (3) über ein Verschlußventil (54) in Verbindung steht und ein Torventil für die Entfernung von Trägern aus der Behandlungskammer bildet,
**dadurch gekennzeichnet**,
daß der Träger (10) mit Mitteln (101) zum Tragen einer Vielzahl von Resonatorelementen (9) in einer Reihe versehen ist, wobei die Symmetriebene der jeweiligen Kristallscheiben (91) in der Längsrichtung der Reihe ausgerichtet ist; daß Transportmittel (80-82) angeordnet sind, um die Träger (10) in der Elektroden-Beschichtungskammer auf einem gegebenen Weg in der Richtung der Reihen der Scheiben (91) auf den Trägern (10) anzutreiben; daß Mittel (11, 104) angeordnet sind, um jedes Resonatorelement (9) vorübergehend in einer gegebenen Position (3b) längs des Weges in der zweiten Kammer (3) zu halten; und daß Elektroden-Beschichtungsmittel (86) auf mindestens einer Seite des Scheiben-Bewegungsweges angeordnet sind und auf eine zugeordnete Hauptfläche einer Scheibe, welche in der gegebenen Position (3b) angeordnet ist, gerichtet sind.

19. Anlage nach Anspruch 18,
**gekennzeichnet durch**
eine extern steuerbare Maskierungsvorrichtung, welche in der Beschichtungskammer (3) angeordnet ist und zwei Maskierungsplatten (191) enthält, welche mit einer Anzahl von Paaren von Maskierungslöchern (192) versehen sind, wobei die Resonatorelemente vorgesehen sind, zwischen den Maskierungsplatten in der Beschichtungsposition zum Zweck der Ausrichtung der Maskierungslöcher mit jeder Resonatorelementscheibe zu passieren.

20. Anlage nach Anspruch 18 oder 19,
**dadurch gekennzeichnet**,
daß die erste Kammer (1) und/oder die dritte Kammer (4) vorgesehen ist, eine Vielzahl von Trägern (10) aufzunehmen, von welchen jeder eine Vielzahl von Resonatorelementen zur gleichzeitigen Reinigung der Träger und der Elemente trägt, und daß Mittel zum individuellen Ausrichten eines Trägers (10) in einer jeweiligen ersten und dritten Kammer (1; 4) vorgesehen sind, und daß Transportvorrichtungen (80) zur linearen Übertragung eines Trägers vorgesehen sind.

21. Anlage nach einem der Ansprüche 18 und 20,
**dadurch gekennzeichnet**,
daß die Träger (10) aus Metall gemacht sind.

22. Anlage nach einem der Ansprüche 18 und 20,
**dadurch gekennzeichnet,**
daß die Träger (10) aus einem isolierenden Material, wie einem Keramik- oder Glasmaterial, gemacht sind.

23. Anlage nach einem der Ansprüche 18 bis 22,
**gekennzeichnet durch**
Federvorrichtungen (170), welche in der Elektroden-Beschichtungsposition (3b) wirken, um die Leiter (94) des Resonatorelements (9) mit einer Frequenz-Ermittlungsschaltung zu verbinden.

24. Anlage nach einem der Ansprüche 18 bis 23,
**dadurch gekennzeichnet,**
daß die Transportvorrichtung (80) entsprechende Rollen (81, 82) enthält, welche mit jeweiligen gegenüberliegenden, sich längs erstreckenden Nuten (106, 107) im Träger (10) in Eingriff stehen, und daß die Nuten (106, 107) sich parallel zur Richtung der Reihe der Resonatorelemente (9) erstrecken, daß mindestens eine (81) der Rollen angetrieben ist, und daß mindestens eine (82) der Rollen beweglich befestigt ist, so daß sie die Stange (10) elastisch gegen befestigte Führungsrollen klemmt.

25. Anlage nach einem der Ansprüche 18 bis 24,
**dadurch gekennzeichnet**,
daß die erste Kammer (1) und/oder die dritte Kammer (4) einen drehbaren Ständer (70) enthält, welcher mit einer Vielzahl von im allgemeinen radial sich ersteckenden Führungen (71) versehen ist, welche wirken, um die einzelnen Träger (10) zu tragen, daß die Führungen (71) vorgesehen sind, einen jeweiligen Träger (10) zur Bewegung in der Richtung der Reihe der Resonatorelemente zu führen, daß der Ständer (70) zu Positionen drehbar ist, in welchen die einzelnen Führungen (71) einen Träger (10) zu der Transportvorrichtung (80) hin führen, und die Anlage ist ferner gekennzeichnet durch eine Schubvorrichtung (61, 62) zum Schieben eines Trägers (10) längs seiner Führung (71).

26. Anlage nach einem der Ansprüche 18 bis 25,
**dadurch gekennzeichnet**,
daß Trockenätz-Vorrichtungen (85) stationär in der zweiten Kammer (3) auf mindestens einer Seite des Weges, welcher durch die Resonatorscheiben (91) zurückgelegt wird, montiert sind, und daß Mittel (11, 104) zum vorübergehenden Halten der Resonatorscheiben (91) jedes Resonatorelements (9) in der Position der Bearbeitungsstation der Ätzvorrichtungen vorgesehen sind.

27. Anlage nach einem der Ansprüche 18 bis 26,
**dadurch gekennzeichnet**,
daß die Elektroden-Beschichtungsvorrichtungen mindestens eine Sputtermagnetron-Quelle enthalten, welche von einem vorzugsweise gekühlten Gehäuse (87) umgeben ist, welches eine Auslaßöffnung (88) hat, in welcher ein Magnet (89) zum Aufhalten von Elektronen befestigt ist.

28. Anlage nach einem der Ansprüche 18 bis 27,
**dadurch gekennzeichnet**,
daß die Elektroden-Beschichtungsvorrichtungen Sputtermagnetron-Quellen enthalten, welche mit einer getrennten Anode versehen sind, an welche eine Gleichspannung für eine Hochfrequenz angelegt werden kann.

29. Anlage nach einem der Ansprüche 18 bis 28,
**dadurch gekennzeichnet**,
daß die Elektroden-Beschichtungskammer (3) mit einem Wärmetauscher zum Einstellen der Temperatur des Resonatorelements während des Elektroden-Beschichtungsverfahrens versehen ist.

30. Anlage nach einem der Ansprüche 18 bis 29,
**dadurch gekennzeichnet**,
daß mindestens eine der Kammern (1, 4), welche mit der Elektroden-Beschichtungskammer (3) verbunden ist, mit Mitteln zur Wärmebehandlung der Resonatorelemente unter Hochvakuumbedingungen oder in einer Betriebsgas-Umgebung versehen ist.

31. Anlage nach einem der Ansprüche 18 bis 30,
**dadurch gekennzeichnet**,
daß Mittel zum Bewirken einer Oxidationsbehandlung in mindestens einer der Kammern (1, 4), welche mit der Elektroden-Beschichtungskammer (3) verbunden ist, angeordnet sind, wobei die Oxidationsmittel vorzugswesie in einer getrennten zusätzlichen Kammer (2), welche zwischen der ersten Kammer (1) und der zweiten Kammer (3) befestigt ist, angeordnet sind.

32. Anlage nach einem der Ansprüche 19 bis 31,
**dadurch gekennzeichnet**,
daß die erste Kammer und die dritte Kammer (4) ein und dieselbe Kammer sind.

## Revendications

1. Un procédé pour fabriquer des résonateurs, chacun d'entre eux comportant un support (93) ayant au moins deux éléments de support mutuellement séparés (92) qui sont connectés à un conducteur de connexion respectif (94), et un disque piézo-électrique (91) qui comporte un plan central entre ses surfaces majeures mutuellement opposées, et qui est monté sur, et fixé de manière conductrice aux éléments support (92) de façon à former un élément résonateur, dans lequel une électrode (98) est appliquée sur chacune des surfaces majeures du disque (91) et est connectée électriquement à un élément support respectif (92), ledit procédé comprenant les étapes: de placement d'une pluralité d'éléments résonateurs fabriqués à l'avance (9) sur un dispositif porteur; d'introduction du dispositif porteur (10) dans une première chambre à vide (1) pour nettoyer le porteur dans celle-ci à un premier niveau de vide; de transfert du porteur (10) avec les éléments (9) directement depuis la première chambre (1) vers une deuxième chambre à vide (3) qui est connectée à ladite première chambre et dans laquelle un deuxième niveau de vide prévaut; d'application d'un matériau de matériau d'électrode aux éléments résonateurs dans ladite deuxième chambre (3); de réglage fin de la fréquence de résonateur de l'élément résonateur revêtu de matériau d'électrode dans ladite deuxième chambre à une valeur souhaitée; et de transfert du porteur (10) avec ledit élément résonateur réglé en fréquence et revêtu de matériau d'électrode depuis la deuxième chambre (3) vers une troisième chambre (4) connectée à ladite deuxième chambre (3), ladite troisième chambre formant une valve d'ouverture d'amenée de porteur, caractérisé par les étapes supplémentaires: de montage d'une pluralité d'éléments résonateurs (9) sur le porteur (10) dans une rangée, le plan central de chaque disque (91) étant orienté dans la direction longitudinale de ladite rangée; de déplacement du porteur (10) dans la direction longitudinale de la rangée dans ladite deuxième chambre, le long d'un trajet donné; d'arrêt dudit déplacement longitudinal du porteur de façon à positionner temporairement le disque (91) de chaque élément (9) dans une position donnée (3b), dans lequel au moins un dispositif de revêtement monté de façon fixe (86) est dirigé contre une surface majeure associée du disque (91) dans ladite position donnée (3b), et dans lequel ledit dispositif de revêtement est amené à appliquer du matériau d'électrode sur l'élément résonateur pendant que ledit élément est maintenu dans ladite position donnée.

2. Un procédé selon la revendication 1, caractérisé en ce que la première et la troisième chambres (1, 4) sont des chambres à vide élevé; en ce que la deuxième chambre (3) est une chambre à vide ultra élevé; et en ce que après avoir été évacuée. du gaz est introduit dans au moins l'une des chambres d'une façon contrôlée, jusqu'à ce qu'une pression de processus souhaitée soit atteinte.

3. Un procédé selon la revendication 1 ou 2, caractérisé par l'exécution d'un processus de traitement thermique sous vide ou dans un environnement de gaz de processus dans l'une au moins des chambres (1, 4) qui est connectée à la deuxième chambre (3).

4. Un procédé selon la revendication 1 ou 2, caractérisé en ce que les éléments résonateurs (9) sont nettoyés par attaque de surface dans la deuxième chambre (3) en irradiant lesdits éléments avec des atomes, des ions, des électrons, des photons ou du plasma, de préférence des atomes; et en ce que les dispositifs d'irradiation (85) sont montés de préférence dans des positions fixes opposées les unes aux autres, des deux côtés du trajet de déplacement des disques des éléments (91), dans une position longitudinale (3a) pour les éléments (9) pour laquelle lesdits éléments sont temporairement maintenus fixes et centrés en relation avec les dispositifs d'irradiation (85) pendant le processus d'attaque.

5. Un procédé selon l'une quelconque des revendications 1 à 4, caractérisé par le traitement des éléments résonateurs avec de la lumière ultraviolette et de l'ozone, avant introduction desdits éléments dans la deuxième chambre (3).

6. Un procédé selon la revendication 5, caractérisé par l'exécution du processus de traitement par U.V. (aux ultraviolets) et à l'ozone dans une chambre de pré-traitement séparée (2) qui est connectée entre la première chambre (1) et la deuxième chambre (3), et qui peut être séparée desdites première et deuxième chambres au moyen de valves d'amenée (52, 53).

7. Un procédé selon l'une quelconque des revendications 1 à 6, caractérisé par le revêtement de matériau d'électrode simultanément sur les deux surfaces majeures du disque (91) dans la deuxième chambre (3), à l'aide de deux dispositifs de revêtement mutuellement opposés (86).

8. Un procédé selon l'une quelconque des revendications 1 à 7, caractérisé par la surveillance de la température de l'élément résonateur pendant le processus de revêtement de matériau d'électrode, à l'aide d'un thermostat.

9. Un procédé selon l'une quelconque des revendications 1 à 8, caractérisé par l'exécution du processus de revêtement de matériau d'électrode à l'aide d'un processus de pulvérisation cathodique, et l'empêchement des électrons générés sur le revêtement de venir frapper le disque (91).

10. Un procédé selon l'une quelconque des revendications 1 à 9, caractérisé par l'application également à la source de pulvérisation cathodique, d'une tension positive en courant continu et/ou d'une tension à haute fréquence par rapport au disque (91).

11. Un procédé selon l'une quelconque des revendications 1 à 10, caractérisé par la détection de la fréquence du résonateur dans la position de revêtement de matériau d'électrode et de préférence, le revêtement de matériau d'électrode de l'élément en une seule étape de revêtement de matériau d'électrode.

12. Un procédé selon l'une quelconque des revendications 1 à 11, caractérisé par le traitement d'une pluralité de porteurs (10) portant chacun simultanément une pluralité d'éléments résonateurs (9) dans la première chambre (1); et par le transfert des porteurs (10) dans la deuxième chambre, de préférence de façon unique et dans la direction de leur axe longitudinal.

13. Un procédé selon l'une quelconque des revendications 1 à 12, caractérisé en ce que deux plaques de masquage (191) pourvues d'un certain nombre de paires de trous de masquage d'électrode associés sont agencées de façon mobile dans la deuxième chambre (3) de façon à positionner les trous de masquage sélectionnés associés à une paire entre les surfaces majeures respectives du disque (91) et un dispositif de revêtement correspondant (86).

14. Un procédé selon l'une quelconque des revendications 1 à 13, caractérisé par l'exécution d'un processus de traitement UV-ozone soit dans la première chambre (1), soit dans la troisième chambre (4).

15. Un procédé selon l'une quelconque des revendications 1 à 14, caractérisé en ce que la première chambre (1) et la troisième chambre (4) sont une seule et même chambre; et en ce que le porteur est enlevé de la chambre de traitement par la même chambre de pré-traitement que celle à travers laquelle il a été introduit dans ladite chambre de revêtement.

16. Un procédé selon l'une quelconque des revendications 1 à 15, caractérisé par le retour des porteurs (10) vers la première chambre après avoir été revêtus de matériau d'électrode.

17. Un procédé selon la revendication 16, caractérisé par la soumission d'un réseau de porteurs (10) avec des éléments résonateurs, à un processus à vide élevé dans la troisième chambre (4), pendant qu'un réseau de porteurs (10) avec des éléments résonateurs traités dans la première chambre (1) sont revêtus de matériau d'électrode dans la deuxième chambre (3).

18. Une installation de fabrication pour la fabrication de résonateurs. chacun d'entre eux comportant un support (93) ayant au moins deux éléments de support mutuellement séparés (92) qui sont connectés des conducteurs de connexion respectifs (94), et un disque piézo-électrique (91) qui comporte un plan central entre ses surfaces majeures mutuellement opposées, et qui est monté sur, et fixé de manière électriquement conductrice aux éléments support (92) de façon à former un élément résonateur (9), dans lequel une électrode (98) est appliquée sur chacune des surfaces majeures du disque (91) et est connectée électriquement à un élément support respectif (92), dans laquelle l'installation comporte des chambres à vide (1, 3, 4) dans lesquelles les résonateurs sont acheminés tandis qu'ils sont portés par des porteurs respectifs (10), dans laquelle les chambres (1, 3, 4) comportent une première chambre de traitement (1) dans laquelle les éléments résonateurs sont nettoyés; une deuxième chambre de traitement (3) dans laquelle des revêtements de matériau d'électrode (98) sont appliqués sur les éléments résonateurs (9). ladite chambre (3) étant connectée à la première chambre (1) par l'intermédiaire d'une valve de fermeture (52), et une troisième chambre, une chambre d'après traitement (4) qui est connectée à la chambre de revêtement (3) par l'intermédiaire d'une valve de fermeture (54) et forme une valve de passage pour le retrait des porteurs de la chambre de traitement, caractérisée en ce que le porteur (10) est pourvu de moyens (101) pour soutenir une pluralité d'éléments résonateurs (9) dans une rangée. le plan de symétrie des disques de cristaux respectifs (91) étant orientés dans la direction longitudinale de ladite rangée; en ce que des moyens d'acheminement (80 à 82) sont agencés pour entraîner les porteurs (10) dans la chambre de revêtement de matériau d'électrode dans un trajet donné dans la direction des rangées des disques (91) sur les porteurs (10): en ce que des moyens (11, 104) sont agencés pour maintenir chaque élément résonateur (9) temporairement dans une position donnée (3b) le long du trajet dans ladite deuxième chambre (3); et en ce que des moyens de revêtement de matériau d'électrode (86) sont agencés sur au moins un côté du trajet de déplacement des disques et sont dirigés vers une surface majeure associée d'un disque situé dans ladite position donnée (3b).

19. Une installation selon la revendication 18, caractérisée par un dispositif de masquage pouvant être commandé extérieurement, positionné dans la chambre de revêtement (3) et comprenant deux plaques de masquage (191) qui sont pourvues d'un certain nombre de trous de masquage (192), dans laquelle les éléments résonateurs sont destinés à passer entre les plaques de masquage dans ladite position de revêtement, dans le but d'aligner les trous de masquage avec chaque disque d'élément résonateur.

20. Une installation selon la revendication 18 ou 19, caractérisée en ce que la première chambre (1) et/ou la troisième chambre (4) sont destinées à recevoir une pluralité de porteurs (10), portant chacun une pluralité d'éléments résonateurs pour le nettoyage simultané desdits porteurs et desdits éléments; et en ce que des moyens sont prévus pour aligner individuellement un porteur (10) dans une première et une troisième chambres respectives (1; 4); et en ce que des dispositifs d'acheminement (80) sont prévus pour le transfert linéaire d'un porteur.

21. Une installation selon l'une quelconque des revendications 18 et 20. caractérisée en ce que les porteurs (10) sont réalisés en métal.

22. Une installation selon l'une quelconque des revendications 18 et 20, caractérisée en ce que les porteurs (10) sont réalisés en un matériau isolant, tel qu'un matériau en céramique ou en verre.

23. Une installation selon l'une quelconque des revendications 18 à 22, caractérisée par des dispositifs élastiques (170) qui, dans ladite position de revêtement de matériau d'électrode (3b), agissent en connectant les conducteurs (94) de l'élément résonateur (9) à un circuit de détection de fréquence.

24. Une installation selon l'une quelconque des revendications 18 à 23, caractérisée en ce que le dispositif d'acheminement (80) comporte des galets correspondants (81, 82) qui s'engagent dans des rainures respectives opposées s'étendant longitudinalement (106, 107), situées dans le porteur (10); et en ce que les rainures (106, 107) s'étendent parallèlement à la direction de ladite rangée d'éléments résonateurs (9); en ce qu'au moins l'un (81) des galets est entraîné; et en ce qu'au moins l'un (82) des galets est monté de façon mobile de manière à pincer la barre (10) de façon élastique contre des galets de guidage fixes.

25. Une installation selon l'une quelconque des revendications 18 à 24, caractérisée en ce que la première chambre (1) et/ou la troisième chambre (4) comportent un support rotatif (70) qui est pourvu d'une pluralité de guides (71) s'étendant généralement radialement, qui agissent en soutenant des porteurs individuels (10); en ce que les guides (71) sont destinés à guider un porteur respectif (10) pour un déplacement dans la direction de la rangée des éléments résonateurs; en ce que le support (70) peut tourner vers des positions dans lesquelles les guides individuels (71) guident un porteur (10) vers le dispositif d'acheminement (80); et est caractérisée en outre par un dispositif de poussée (61, 62) pour pousser un porteur (10) le long de son guide (71).

26. Une installation selon l'une quelconque des revendications 18 à 25, caractérisée en ce que des dispositifs d'attaque à sec (85) sont montés de manière fixe dans la deuxième chambre (3) sur un côté au moins du trajet parcouru par les disques résonateurs (91); et en ce que des moyens (11, 104) sont prévus pour maintenir temporairement le disque résonateur (91) de chaque élément résonateur (9) dans la position de la station de travail desdits dispositifs d'attaque.

27. Une installation selon l'une quelconque des revendications 18 à 26, caractérisée en ce que les dispositifs de revêtement de matériau d'électrode comportent au moins une source magnétron de pulvérisation qui est entourée par un boîtier (87) de préférence refroidi, comportant une ouverture de sortie (88) dans laquelle un aimant (89) est monté pour faire obstacle aux électrons.

28. Une installation selon l'une quelconque des revendications 18 à 27, caractérisée en ce que les dispositifs de revêtement de matériau d'électrode comportent des sources magnétron de pulvérisation qui sont pourvues d'une anode séparée à laquelle peut être appliquée une tension en courant continu pour une fréquence élevée.

29. Une installation selon l'une quelconque des revendications 18 à 28, caractérisée en ce que la chambre de revêtement de matériau d'électrode (3) est pourvue d'un échangeur de chaleur pour régler la température des éléments résonateurs pendant le processus de revêtement de matériau d'électrode.

30. Une installation selon l'une quelconque des revendications 18 à 29, caractérisée en ce qu'au moins l'une des chambres (1, 4) connectée à la chambre de revêtement de matériau d'électrode (3) est pourvue de moyens pour traiter thermiquement les éléments résonateurs dans des conditions de vide élevé ou dans un environnement de gaz de traitement.

31. Une installation selon l'une quelconque des revendications 18 à 30, caractérisée en ce que des moyens pour effectuer un traitement d'oxydation sont agencés dans au moins une des chambres (1, 4) connectée à la chambre de revêtement de matériau d'électrode (3), lesdits moyens d'oxydation, étant de préférence agencés dans une chambre supplémentaire séparée (2), qui est connectée entre la première chambre (1) et la deuxième chambre (3).

32. Une installation selon l'une quelconque des revendications 19 à 31, caractérisée en ce que la première chambre et la troisième chambre (4) sont une seule et même chambre.
